# DEMANDE DE BREVET EUROPEEN

(11) **EP 0 991 193 A1**
(43) Date de publication de la demande: **05.04.2000**
(21) Numéro de dépôt: 99203093.2
(22) Date de dépôt: 21.09.1999
(51) Int. Cl.: H03L 7/089, H03D 13/00

(54) **Appareil radioélectrique comportant un synthétiseur de fréquence et discriminateur de phase pour un tel appareil**

(30) Priorité: 29.09.1998 FR 9812162
(71) Demandeur: Koninklijke Philips Electronics N.V., 5621 BA Eindhoven (NL)
(72) Inventeur: Chabas, Jean Alain, 75008 Paris (FR)
(74) Mandataire: Chaffraix, Jean

(57) **Abrégé**

L'appareil de l'invention est muni d'un synthétiseur de fréquences (30) du type à verrouillage de phase. Pour obtenir un verrouillage rapide, on a disposé un discriminateur de phase (40) présentant une caractéristique optimale. Quand il n'y a pas de verrouillage de phase, sa tension de sortie reste constante, ce qui donne un gain important à la boucle pour obtenir la capture. Lorsqu'il y a verrouillage, le discriminateur donne une erreur proportionnelle à l'écart de phase. Le discriminateur de phase (40) comprend des premier et second circuits séquentiels, le premier circuit séquentiel (51,52,55) fournissant des signaux représentatifs de l'écart de phase alors que le deuxième circuit séquentiel (61,62) fournit un signal constant lorsqu'une différence de fréquence est détectée. Le premier circuit séquentiel (51,52,55) comprend avantageusement deux bascules de type D et le deuxième circuit séquentiel (61,62) peut comprendre deux bascules de type JK.

Application aux radiotéléphones.

## Description

La présente invention concerne un appareil radioélectrique comportant un synthétiseur de fréquences pourvu notamment d'un discriminateur de phase pour comparer la phase d'un premier signal avec la phase d'un deuxième signal, discriminateur formé d'un premier circuit séquentiel pour fournir des signaux de sortie représentatifs de l'écart de phase desdits premier et deuxième signaux.

L'invention concerne aussi un tel discriminateur et un procédé pour comparer les différents états de phase de deux signaux.

De tels appareils sont bien connus et trouvent de nombreuses applications, notamment dans le domaine des appareils de téléphonie portables qui utilisent une multitude de canaux de fréquences déterminés par le synthétiseur. On rappelle qu'un synthétiseur se compose essentiellement d'un oscillateur variable à commande par tension asservi sur une fréquence de référence après une division de fréquence qui détermine finalement la fréquence de sortie du synthétiseur.

Lorsque l'appareil est à l'état de veille, il doit se raccorder au réseau de manière plus ou moins périodique et pour des raisons d'économie de l'énergie d'alimentation il est souhaitable que le synthétiseur soit au repos le plus longtemps possible c'est-à-dire que cela implique de synchroniser, le plus rapidement possible, l'oscillateur variable sur la fréquence de référence. Un des éléments qui permet d'obtenir une synchronisation rapide est le discriminateur de phase. On trouvera dans le document de brevet EP 0 500 014 la description d'un tel discriminateur.

Si ce discriminateur connu donne de bonnes indications en ce qui concerne les différences de phase entre -π et +π, ces indications ne sont plus suffisantes pour des écarts de phase supérieurs donc pour des signaux ayant des fréquences différentes.

L'invention propose un appareil dans lequel le discriminateur présente une bonne caractéristique d'état de phase, pour obtenir notamment une rapide synchronisation de l'oscillateur variable.

Pour cela un tel appareil est remarquable en ce que le discriminateur comporte un deuxième circuit séquentiel pour fournir un signal constant lorsque lesdits premier et deuxième signaux ont des fréquences différentes.

Ainsi, grâce à l'invention, lorsque les fréquences des signaux sont différentes, le signal continu dont la valeur est égale à un maximum permet de corriger rapidement la fréquence de l'oscillateur à commande par tension pour obtenir sa synchronisation avec le maximum de vitesse.

La description suivante, faite en regard des dessins ci-annexés, le tout donné à titre d'exemple non limitatif, fera bien comprendre comment l'invention peut être réalisée.
La figure 1 montre un appareil conforme à l'invention.
La figure 2 montre le schéma d'un synthétiseur faisant partie de l'appareil de la figure 1.
La figure 3 montre le schéma d'un discriminateur faisant partie du synthétiseur de la figure 2.
La figure 4 est un premier diagramme temps destiné à l'explication du discriminateur de la figure 3.
La figure 5 est un deuxième diagramme temps destiné à l'explication du discriminateur de la figure 3.
La figure 6 représente la courbe de réponse du discriminateur.

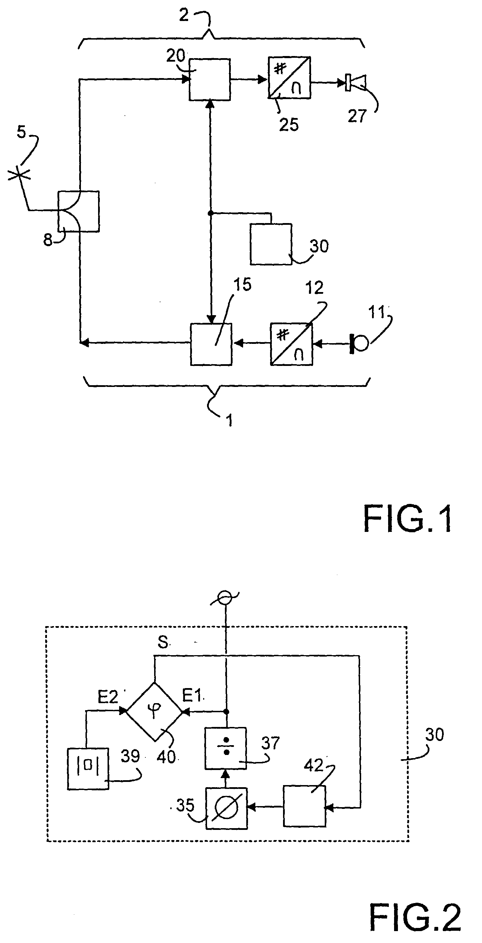

A la figure 1, on a représenté un appareil radioélectrique conforme à l'invention. Il est composé d'une chaîne d'émission 1 et d'une chaîne de réception 2 couplées à une antenne 5 par l'intermédiaire d'un duplexeur 8. La chaîne d'émission 1 est constituée par un microphone 11 suivi d'un convertisseur analogique numérique 12 qui fournit les signaux de conversation à transmettre à un système de modulation 15. La chaîne de réception 2 se compose d'un système de démodulation 20 suivi d'un décodeur 25 et d'un écouteur 27. Les systèmes de réception et d'émission sont pilotés sur le canal de fréquence au moyen d'un synthétiseur 30.

La figure 2 montre la structure du synthétiseur 30 d'un type conventionnel. Il se compose d'un oscillateur à commande par tension 35 dont les signaux sont divisés en fréquence par un diviseur de fréquence 37. Le taux de division de fréquence détermine le canal de fréquence sur lequel on veut trafiquer. Le signal E1 qui est le signal de sortie du diviseur 37 est comparé, au moyen d'un discriminateur de phase 40, à un signal E2 qui est le signal de sortie d'un oscillateur à quartz 39. Le signal de sortie S de ce discriminateur est appliqué à la commande par tension de l'oscillateur 35 par l'intermédiaire d'un filtre d'asservissement 42.

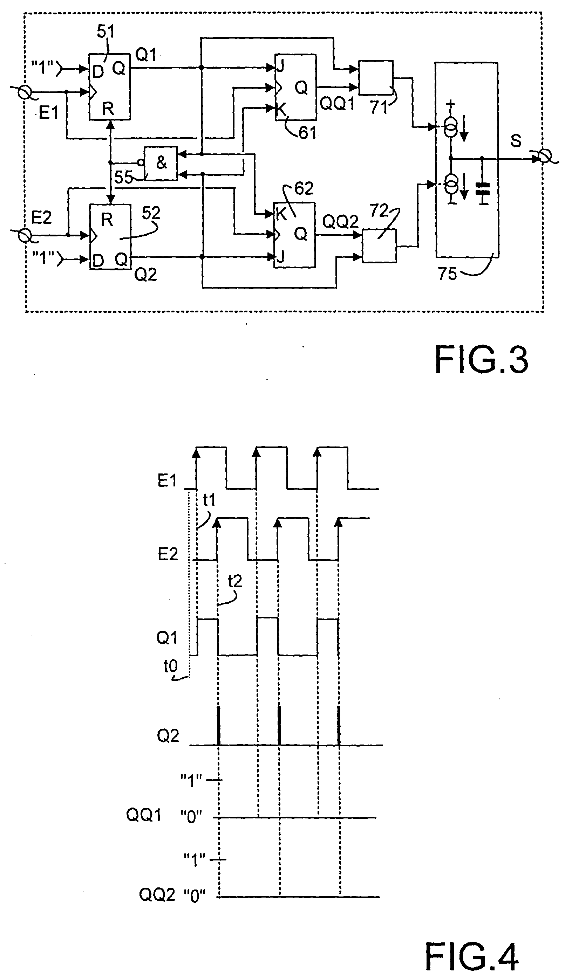

La figure 3 montre en détail le discriminateur de phase conforme à l'invention.

Les signaux E1 et E2 sont respectivement appliqués aux entrées d'horloge de deux bascules de type D portant les références respectives 51 et 52. Ces bascules reçoivent en permanence un signal de valeur logique 〈〈 1 〉〉 sur leur entrée D tandis que leur entrée R reçoit le signal de sortie d'une porte NON-ET 55. Les signaux de sortie Q1 et Q2 de ces bascules 51 et 52 sont appliqués, outre aux entrées de la porte 55, aux entrées J des bascules 61 et 62 de type JK, aux entrées K des bascules 61 et 61 et aux premières entrées des portes OU 71 et 72. Les sorties de ces bascules 61 et 62 sont appliquées aux entrées d'un circuit connu sous le nom de pompe de courant 75 de type conventionnel. Les deuxièmes entrées de ces portes 71 et 72 sont reliées aux sorties de ces dernières bascules 61 et 62. Les entrées d'horloge des bascules 61 et 62 reçoivent respectivement les signaux E1 et E2 et leur sortie Q fournit les signaux QQ1 et QQ2 respectivement.

En résumé, ce discriminateur se compose d'un premier circuit séquentiel constitué à partir des bascules 51 et 52 qui a la structure des discriminateurs de phase connus, d'un deuxième circuit séquentiel constitué à partir des bascules 61 et 62 et d'un circuit de couplage, formé essentiellement des portes OU 71 et 72, qui permet d'alimenter en signaux de commande la pompe de courant 75 à partir de ces circuits séquentiels.

Le fonctionnement du discriminateur est expliqué pour un premier mode de fonctionnement à l'aide de la figure 4. Ce mode concerne le cas où les signaux E1 et E2 ont la même fréquence. On se place à l'instant t0 et l'on considère que les signaux Q1 et Q2 aux sorties des bascules sont à l'état logique 〈〈 0 〉〉. A l'instant t1 survient la transition montante du signal E1 pour lequel les bascules sont sensibles de sorte que la bascule 51 transfert la valeur 〈〈 1 〉〉 qui était présente à son entrée D à sa sortie Q. Le signal Q1 prend alors la valeur 〈〈 1 〉〉. A l'instant t2 c'est le front montant du signal E2 qui survient ce qui fait que le signal Q2 à la sortie de la bascule 52 prend la valeur 〈〈 1 〉〉. Mais, cet état change du fait qu'un signal actif, provenant de la porte 55, de valeur 〈〈 0 〉〉 est appliqué aux entrées R des bascules 51 et 52. Donc après l'instant t2 les signaux Q1 et Q2 prennent la valeur 〈〈 0 〉〉.

En ce qui concerne les bascules 61 et 62, il convient de remarquer qu'avant les transitions actives du signal E1 le signal Q1 a la valeur 〈〈 0 〉〉 et le signal Q2 la valeur 〈〈 0 〉〉 ce qui fait que le signal QQ1 garde sa valeur. Il convient de remarquer aussi qu'avant les transitions actives du signal E2 le signal Q1 a la valeur 〈〈 1 〉〉 et le signal Q2 la valeur 〈〈 0 〉〉 ce qui fait le signal QQ2 prend la valeur 〈〈 0 〉〉. Ainsi, les portes OU 71 et 72 sont ouvertes et le fonctionnement du discriminateur reste celui des discriminateurs de l'art antérieur.

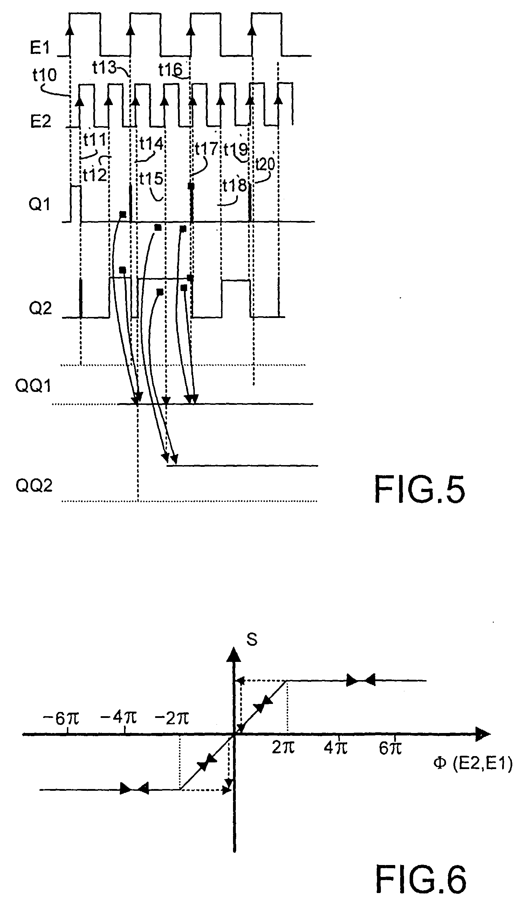

Le fonctionnement du discriminateur selon un autre mode pour lequel les signaux ont des fréquences différentes est expliqué à l'aide de la figure 5. Ainsi sur cette figure, se produisent entre une première transition du signal E1 qui survient à l'instant t10 et une deuxième transition de ce même signal, deux transitions du signal E2 apparaissant aux instants t11 et t12. Comme la transition de E2 survenant à l'instant t11 est postérieure à l'instant t10, on est donc sûr qu'à l'instant t12 les signaux Q1 et Q2 ont la valeur 〈〈 0 〉〉. Ainsi, après cet instant t12 on a Q2= 〈〈 1 〉〉 et Q1= 〈〈 0 〉〉 de sorte qu'à l'instant t13 où apparaît une transition active de E1, Q1 prend la valeur 〈〈 1 〉〉 pour la perdre aussitôt par suite du signal de sortie de la porte 55.
Après cet instant t13, le signal QQ1 prend la valeur 〈〈 0 〉〉.
Puis survient à l'instant t14, le front actif du signal E2, ce front va agir sur les bascules 52 et 62, le signal Q2 va passer de la valeur 〈〈 0 〉〉 à la valeur 〈〈 1 〉〉 et de ce fait le signal QQ2 aura la valeur 〈〈 1 〉〉.
A l'instant t15, survient encore un front actif du signal E2, le signal Q2 garde sa valeur 〈〈 1 〉〉 tandis que le signal QQ2 est confirmé dans sa valeur 〈〈 1 〉〉.
A l'instant t16, survient un front actif du signal E1, cette fois-ci. Donc, le signal Q1 prend la valeur 〈〈 1 〉〉 pour la perdre aussitôt du fait que la porte NON-ET est rendue passante par le signal Q2. Le signal QQ1 garde la valeur 〈〈 0 〉〉 acquise lors de l'instant t13 puisque à ses entrées J et K il reçoit des signaux 〈〈 0 〉〉 et 〈〈 0 〉〉 respectivement.
A l'instant t17, survient un front montant du signal E2. On admet que ce front survient après la montée fugace du signal Q1 de sorte qu'aux entrées J et K de la bascule 62 on a des signaux 〈〈 0 〉〉 et 〈〈 0 〉〉, donc la bascule garde son état antérieur à l'instant t17.
A l'instant t18, qui est l'instant d'apparition d'un front montant du signal E2, le signal QQ2 garde toujours la valeur 〈〈 1 〉〉. Le même état demeure pour ce signal à l'instant t19 où survient encore un front montant du signal E2.
Avant l'instant t20, les signaux aux entrées J et K de la bascule 62 avaient les valeurs respectives 〈〈 0 〉〉 et 〈〈 1 〉〉 ce qui maintient à 〈〈 0 〉〉 le signal QQ1.

Ainsi, on se rend compte que lorsque les fréquences des signaux sont différentes les signaux QQ1 et QQ2 demeurent constants ce qui permet d'avoir un signal d'erreur qui pousse l'oscillateur 35 (figure 2) à se synchroniser rapidement. Ceci est représenté schématiquement à la figure 6 qui montre la réponse du discriminateur de la figure 3. c'est-à-dire la variation du signal S en fonction de l'erreur de phase et/ou de fréquence des signaux E1 & E2 Φ(E1,E2). On remarquera qu'il existe un effet d'hystérésis. En effet si les fréquences se rapprochent, les signaux QQ1 et QQ2 ne changent pas de valeur. Pour se rendre compte de cela, on considère à la figure 5 que les fronts 18 et 19 ne surviennent plus, les signaux Q1 et Q2 gardent donc la valeur 〈〈 0 〉〉 (courbe en pointillés) ce qui fait qu'aucune des bascules 61 et 62 ne change d'état. Lorsqu'on atteint une coïncidence de phase, on décrit alors la courbe en trait plein de la figure 6.

Il est possible de réaliser autrement les circuits de l'invention. Par exemple, en utilisant des circuits logiques couplés à des éléments de mémoires.

## Revendications

1. Appareil radioélectrique comportant un synthétiseur de fréquences pourvu notamment d'un discriminateur de phase pour comparer la phase d'un premier signal avec la phase d'un deuxième signal, discriminateur formé d'un premier circuit séquentiel pour fournir des signaux de sortie représentatifs de l'écart de phase desdits premier et deuxième signaux, caractérisé en ce que le discriminateur comporte un deuxième circuit séquentiel pour fournir un signal constant lorsque lesdits premier et deuxième signaux ont des fréquences différentes.

2. Appareil selon la revendication 1, caractérisé en ce que ledit deuxième circuit séquentiel est formé d'au moins une bascule munie d'une entrée d'horloge pour recevoir respectivement le premier et le deuxième signal et d'un circuit de connexion pour mettre ces bascules dans un état stable pour des fréquences différentes desdits premier et deuxième signaux.

3. Appareil selon la revendication 1 ou 2 dans lequel le discriminateur comporte un circuit à pompe de courant munie d'une entrée de commande pour des signaux logiques, caractérisé en ce que ledit discriminateur comporte un circuit de couplage pour fournir à ladite entrée de commande des signaux définis par ledit deuxième circuit séquentiel lorsque les fréquences desdits premier et deuxième signaux sont différentes et des signaux définis par ledit premier circuit séquentiel lorsque lesdits signaux sont passés par une coïncidence de phase.

4. Discriminateur de phase destiné à un appareil selon l'une des revendications 1 à 3, caractérisé en ce qu'il est formé, entre autres, d'un premier circuit séquentiel pour fournir des signaux de sortie représentatifs de l'écart de phase desdits premier et deuxième signaux et d'un deuxième circuit séquentiel pour fournir un signal continu lorsque lesdits premier et deuxième signaux ont des fréquences différentes.

5. Discriminateur selon la revendication 4 caractérisé en ce qu'il comporte un circuit de couplage pour fournir à ladite entrée de commande des signaux définis par ledit deuxième circuit séquentiel lorsque les fréquences desdits premier et deuxième signaux sont différentes et des signaux définis par ledit premier circuit séquentiel lorsque lesdits signaux sont passés par une coïncidence de phase.

6. Procédé mis en oeuvre dans un appareil selon l'une des revendications 1 à 3 pour commander un synthétiseur de fréquence de signaux, caractérisé en ce qu'on utilise un discriminateur de fréquences qui fournit des signaux d'écart de phase pour des signaux appliqués à ses entrées ayant une même fréquence et des signaux constants pour des signaux appliqués à ses entrées ayant des fréquences différentes.

7. Procédé selon la revendication 6, caractérisé en ce qu'il est prévu un cycle d'hystérésis pour maintenir à un niveau constant le signal de sortie du discriminateur lorsqu' après avoir été de fréquences différentes les signaux présentent ensuite une même fréquence avec une phase différente.
